# EUROPEAN PATENT APPLICATION

(11) **EP 4 572 580 A1**
(43) Date of publication of application: **18.06.2025**
(21) Application number: 22954826.8
(22) Date of filing: 08.12.2022
(51) Int. Cl.: H10K 59/126, H10K 59/121

(54) **DISPLAY PANEL AND DISPLAY APPARATUS**

(30) Priority: 11.08.2022 CN 202210961536; 29.11.2022 CN 202211509545
(71) Applicant: Kunshan Go-Visionox Opto-Electronics Co., Ltd., KunShan, Jiangsu 215300 (CN)
(72) Inventor: YANG, Xingxing, Suzhou, Jiangsu 215300 (CN); HU, Junlin, Suzhou, Jiangsu 215300 (CN)
(74) Representative: Kraus & Lederer PartGmbB
(86) International application number: PCT/CN2022/137628
(87) International publication number: WO 2024/031888

(57) **Abstract**

The present application provides a display panel and a display apparatus. The display panel includes: a base plate; and a light shielding layer including a first light shielding unit, a second light shielding unit, and a third light shielding unit; outlines of orthographic projections of the first light shielding unit, the second light shielding unit, and the third light shielding unit on the base plate each form a pattern with curved edges, outline dimensions of the orthographic projections of the first light shielding unit, the second light shielding unit, and the third light shielding unit on the base plate are decreased sequentially, and a difference between the outline dimension of the orthographic projection of the second light shielding unit on the base plate and an average of the outline dimensions of the orthographic projections of the first light shielding unit and the third light shielding unit on the base plate is less than or equal to a preset value.

## Description

### CROSS REFERENCE TO RELATED APPLICATION

The present application claims priority to Chinese Patent Application No. 202210961536.4 filed on August 11, 2022, and titled "DISPLAY PANEL AND DISPLAY APPARATUS", and Chinese Patent Application No. 202211509545.6 filed on November 29, 2022, and titled "DISPLAY PANEL AND DISPLAY APPARATUS", all of which are incorporated herein by reference in their entireties.

### TECHNICAL FIELD

The present application relates to the field of display technology, and particularly to a display panel and a display apparatus.

### BACKGROUND

With the development of display technology, users not only require smooth usage experience for their electronic products, but also have higher and higher requirements for visual experience, and a high screen-to-body ratio has become the direction of current research. For electronic products, an optical element such as a front camera will inevitably occupy some space, which affects the screen-to-body ratio. In order to increase the screen-to-body ratio and achieve full screen display, researchers consider solutions with under-screen optical elements.

In the prior art, an optical element such as a camera is usually arranged under a display panel, however, since the display panel generally includes a light shielding structure, diffraction occurs when light reaches the optical element through the display panel, which will significantly affect the normal operation of the optical element.

Therefore, there is an urgent need for a new display panel and a new display apparatus.

### SUMMARY

Embodiments of the present application provide a display panel and a display apparatus, by setting a difference between an outline dimension of a orthographic projection of a second light shielding unit on a base plate and an average of outline dimensions of orthographic projections of a first light shielding unit and a third light shielding unit on the base plate to be less than or equal to a preset value, the diffraction of external light at the first light shielding unit, the second light shielding unit, and the third light shielding unit can be adjusted to reduce the effect of diffraction on the operation of the optical element, thereby improving the operation of the optical element.

In a first aspect, some embodiments of the present application provide a display panel with a display area and a non-display area, the display area including a first sub-pixel area, a second sub-pixel area, and a third sub-pixel area emitting lights of different colors, the display panel including: a base plate; and a light shielding layer arranged at a side of the base plate and including a first light shielding unit located in the first sub-pixel area, a second light shielding unit located in the second sub-pixel area, and a third light shielding unit located in the third sub-pixel area; in which outlines of orthographic projections of the first light shielding unit, the second light shielding unit, and the third light shielding unit on the base plate each form a pattern with curved edges, outline dimensions of the orthographic projections of the first light shielding unit, the second light shielding unit, and the third light shielding unit on the base plate are decreased sequentially, and a difference between the outline dimension of the orthographic projection of the second light shielding unit on the base plate and an average of the outline dimensions of the orthographic projections of the first light shielding unit and the third light shielding unit on the base plate is less than or equal to a preset value.

In a second aspect, some embodiments of the present application provide a display apparatus including the display panel in any of the above embodiments.

Compared with the prior art, the display panel according to the embodiments of the present application includes the light shielding layer. The first light shielding unit of the light shielding layer is located in the first sub-pixel area, the second light shielding unit is located in the second sub-pixel area, and the third light shielding unit is located in the third sub-pixel area, and the first light shielding unit, the second light shielding unit, and the third light shielding unit are not light-transmitting and arranged with a high degree of regularity, which is similar to the optical grating in an optical structure, and thus the light entering the optical element from outside may be affected, resulting in diffraction problem. In order to solve the above problem, the inventors have found that by setting the first light shielding unit, the second light shielding unit, and the third light shielding unit as a patten with arc edges, and setting the difference between the outline dimension of the orthographic projection of the second light shielding unit on the base plate and the average of the outline dimensions of the orthographic projections of the first light shielding unit and the third light shielding unit on the base plate to be less than or equal to the preset value, i.e., the outline dimension of the orthographic projection of the second light shielding unit on the base plate is close to the average of the outline dimensions of the orthographic projections of the first light shielding unit and the third light shielding unit on the base plate, the diffraction of external light at the first light shielding unit, the second light shielding unit, and the third light shielding unit can be adjusted to reduce the effect of diffraction on the operation of the optical element, thereby improving the operation of the optical element.

### BRIEF DESCRIPTION OF THE DRAWINGS

Fig. 1 shows a schematic structural diagram of a display panel according to an embodiment of the present application;
Fig. 2 shows a film layer structural diagram at B-B in Fig. 1 according to an embodiment of the present application;
Fig. 3 shows a diagram of orthographic projections of a first light shielding unit, a second light shielding unit, and a third light-shielding unit on a base plate according to an embodiment of the present application;
Fig. 4 shows a film layer structural diagram of an anode layer according to an embodiment of the present application;
Fig. 5 shows a film layer structural diagram at B-B in Fig. 1 according to another embodiment of the present application;
Fig. 6 shows a film layer structural diagram at B-B in Fig. 1 according to yet another embodiment of the present application;
Fig. 7 shows a schematic structural diagram of a pixel arrangement structure according to an embodiment of the present application;
Fig 8 shows a diffraction effect diagram for a second sub-pixel area corresponding to a second light shielding unit in Fig. 7;
Fig. 9 shows a schematic structural diagram of a pixel arrangement structure according to another embodiment of the present application;
Fig. 10 shows a diffraction effect diagram for a second sub-pixel area corresponding to a second light shielding unit in Fig. 9;
Fig. 11 shows a schematic structural diagram of a pixel arrangement structure according to yet another embodiment of the present application;
Fig. 12 shows a diffraction effect diagram for a second sub-pixel area corresponding to a second light shielding unit in Fig. 11;
Fig. 13 shows a diagram of orthographic projections of a first light shielding unit, a second light shielding unit, and a third light-shielding unit on a base plate according to another embodiment of the present application.

### DETAILED DESCRIPTION

The present application is described in further detail below in connection with the accompanying drawings and specific embodiments.

It should be understood that when describing the structure of a component, if a layer or area is referred to as being "above" or "on" another layer or area, it may mean that the layer or area is directly above the other layer or area, or that other layers or areas are between the layer or area and the other layer or area. Furthermore, if the component is turned over, the layer or area will be "below" or "under" the other layer or area.

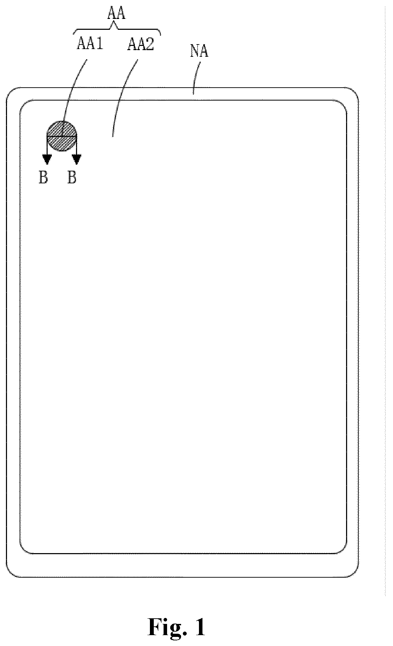

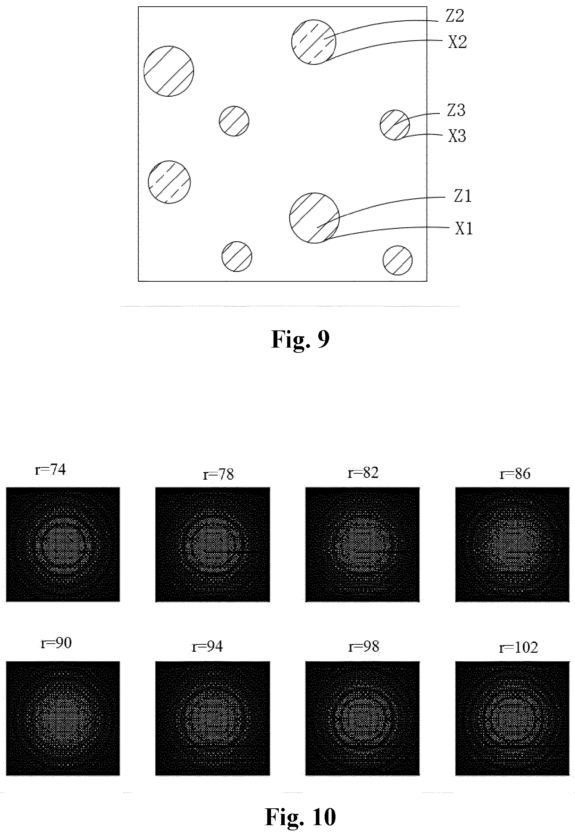

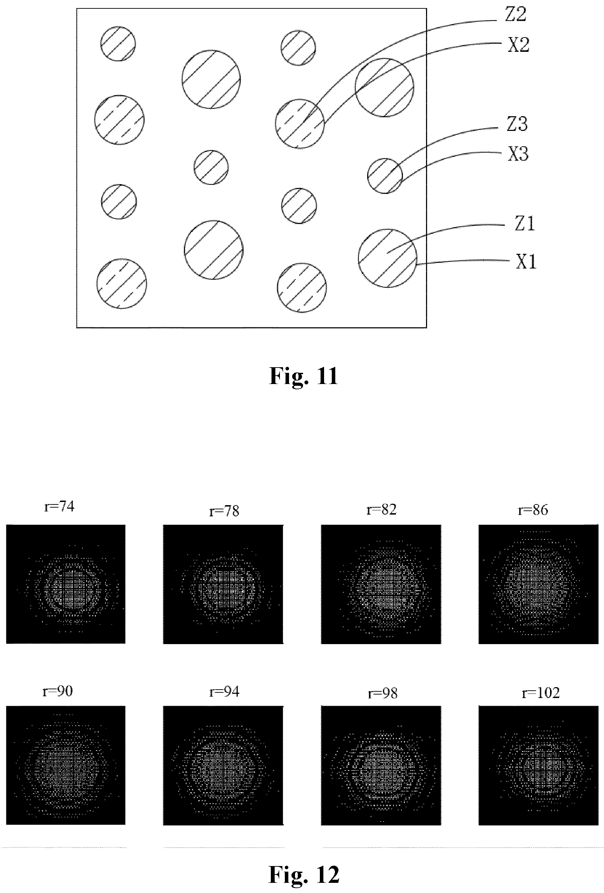

Various embodiments of the display panel and the display apparatus will be described below in connection with Figs. 1 to 13.

The display panel according to the embodiments of the present application may be an Organic Light-Emitting Diode (OLED) display panel, a Quantum Dot Light Emitting Diodes (QLED) display panel, or a micro-planar display panel (Micro-OLED or Micro-LED), etc. In the following, for example, the display panel is an OLED display panel.

Reference is made to Figs. 1 to 3, the embodiments of the present application provide a display panel with a display area AA and a non-display area NA, and the display area AA includes a first sub-pixel area X1, a second sub-pixel area X2, and a third sub-pixel area X3 emitting lights of different colors. The display panel includes: a base plate; and a light shielding layer arranged at a side of the base plate 1 and including a first light shielding unit Z1 located in the first sub-pixel area X1, a second light shielding unit Z2 located in the second sub-pixel area X2, and a third light shielding unit Z3 located in the third sub-pixel area X3. Outlines of orthographic projections of the first light shielding unit Z1, the second light shielding unit Z2, and the third light shielding unit Z3 on the base plate 1 each form a pattern with curved edges, outline dimensions of the orthographic projections of the first light shielding unit Z1, the second light shielding unit Z2, and the third light shielding unit Z3 on the base plate 1 are decreased sequentially, and a difference between the outline dimension of the orthographic projection of the second light shielding unit Z2 on the base plate 1 and an average of the outline dimensions of the orthographic projections of the first light shielding unit Z1 and the third light shielding unit Z3 on the base plate 1 is less than or equal to a preset value.

The display panel according to the embodiments of the present application includes the base plate 1 and the light shielding layer. The first light shielding unit Z1 of the light shielding layer is located in the first sub-pixel area X1, the second light shielding unit Z2 is located in the second sub-pixel area X2, and the third light shielding unit Z3 is located in the third sub-pixel area X3, and the first light shielding unit Z1, the second light shielding unit Z2, and the third light shielding unit Z3 are not light-transmitting and arranged with a high degree of regularity, which is similar to the optical grating in an optical structure, and thus the light entering the optical element from outside may be affected, resulting in diffraction problem. In order to solve the above problem, the inventors have found that by setting the first light shielding unit Z1, the second light shielding unit Z2, and the third light shielding unit Z3 as a patten with arc edges, and setting the difference between the outline dimension of the orthographic projection of the second light shielding unit Z2 on the base plate 1 and the average of the outline dimensions of the orthographic projections of the first light shielding unit Z1 and the third light shielding unit Z3 on the base plate 1 to be less than or equal to the preset value, i.e., the outline dimension of the orthographic projection of the second light shielding unit Z2 on the base plate 1 is close to the average of the outline dimensions of the orthographic projections of the first light shielding unit Z1 and the third light shielding unit Z3 on the base plate 1, the diffraction of external light at the first light shielding unit Z1, the second light shielding unit Z2, and the third light shielding unit Z3 can be adjusted to reduce the effect of diffraction on the operation of the optical element, thereby improving the operation of the optical element.

In the embodiment, the first light shielding unit Z1, the second light shielding unit Z2, and the third light shielding unit Z3 may include a structure with low light transmittance or other structures that are not light-transmitting, for example, an anode, an organic layer, an inorganic layer, and the like in a periodic pattern. When external light passes through the first light shielding unit Z1, the second light shielding unit Z2, and the third light shielding unit Z3, corresponding diffraction patterns may be generated according to the shape of the outer edges of the first light shielding unit Z1, the second light shielding unit Z2, and the third light shielding unit Z3. In adjusting the outline dimension of the orthographic projection of the second light shielding unit Z2 on the base plate 1, the relative distances between the second light shielding unit Z2 and the first light shielding unit Z1/the third light shielding unit Z3 may also be changed accordingly, which may change the diffraction effect. The inventors have found through experiments that if adjusting the outline dimension of the orthographic projection of the second light shielding unit Z2 on the base plate 1 to be close to the average of the outline dimensions of the orthographic projections of the first light shielding unit Z1 and the third light shielding unit Z3 on the base plate 1, the diffraction light intensity is the most convergent and the diffracted lights are more uniformly distributed, while ripple phenomenon is weaker, and thus the diffraction problem of the display panel is significantly alleviated.

The outline dimension specifically refers to the dimension of the pattern formed by the outer edge outline of the orthographic projection of the first light shielding unit Z1, the second light shielding unit Z2, and the third light shielding unit Z3 on the base plate 1.

Optionally, the display area AA includes a first display area AA1 and a second display area AA2 that are adjacent, a light transmittance of the first display area AA1 is greater than a light transmittance of the second display area AA2, and the light shielding layer is arranged at least in the first display area AA1.

It may be understood that the first display area AA1 is a light-transmitting area for arranging optical elements such as a camera and a fingerprint recognition element, and the light transmittance of the first display area AA1 is greater than the light transmittance of the second display area AA2, so that the corresponding optical element can receive sufficient incoming light to ensure the imaging effect.

In some optional embodiments, the preset value is less than or equal to 2 µm, which may mean that the outline dimension of the orthographic projection of the second light shielding unit Z2 on the base plate 1 needs to be within the range of the average of the outline dimensions of the orthographic projections of the first light shielding unit Z1 and the third light shielding unit Z3 on the base plate 1 plus/minus 2 µm.

It may be understood that the reducing of the diffraction problem is most obvious when the outline dimension of the orthographic projection of the second light shielding unit Z2 on the base plate 1 is equal to the average of the outline dimensions of the orthographic projections of the first light shielding unit Z1 and the third light shielding unit Z3 on the base plate 1. However, considering the factors such as manufacturing error and process accuracy, as long as the difference between the outline dimension of the orthographic projection of the second light shielding unit Z2 on the base plate 1 and the average of the outline dimensions of the orthographic projections of the first light shielding unit Z1 and the third light shielding unit Z3 on the base plate 1 is within 2 µm, the diffraction problem can also be alleviated. For example, the preset value may be 0.5 µm, 1 µm, 1.5 µm, 2 µm, and the like, which is not specifically limited, and generally, the smaller the preset value, the greater the reducing of light transmission unevenness due to the diffraction of light.

For ease of manufacturing, only a maximum outline dimension of the orthographic projection of the second light shielding unit Z2 on the base plate 1 may be adjusted, so that the maximum outline dimension of the orthographic projection of the second light shielding unit Z2 on the base plate 1 is equal to an average of maximum outline dimensions of the orthographic projections of the first light shielding unit Z1 and the third light shielding unit Z3 on the base plate 1.

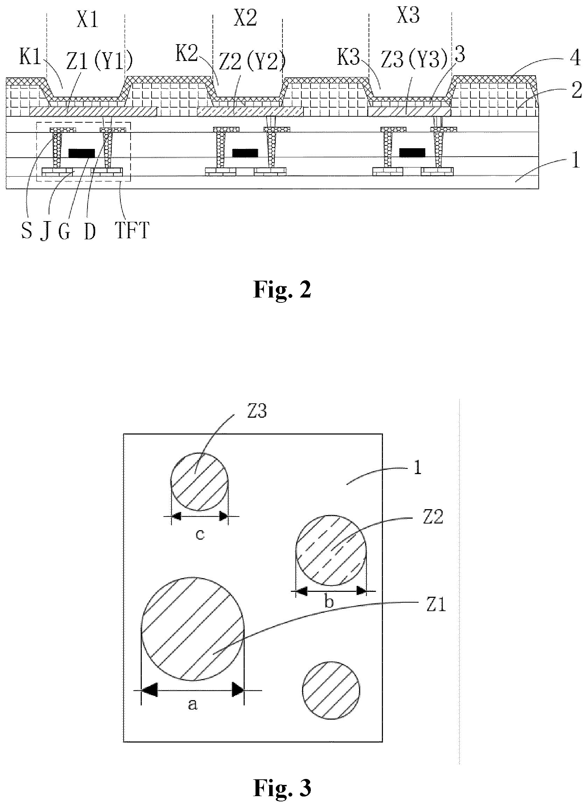

As shown in Fig. 3, the maximum outline dimension of the orthographic projection of the first light shielding unit Z1 on the base plate 1 is *a,* the maximum outline dimension of the orthographic projection of the second light shielding unit Z2 on the base plate 1 is *b,* the maximum outline dimension of the orthographic projection of the third light shielding unit Z3 on the base plate 1 is c, and the preset value is equal to the average of *a* and *c* minus *b.*

Reference is made to Fig. 2, in some optional embodiments, the display panel further includes a pixel defining layer 2 arranged at a side of the base plate 1 and including a first pixel opening K1, a second pixel opening K2, and a third pixel opening K3; an orthographic projection of the first light shielding unit Z1 on the pixel defining layer 2 is at least partially located within the first pixel opening K1, an orthographic projection of the second light shielding unit Z2 on the pixel defining layer 2 is at least partially located within the second pixel opening K2, and an orthographic projection of the third light shielding unit Z3 on the pixel defining layer 2 is at least partially located within the third pixel opening K3.

It should be noted that the size of the first sub-pixel area X1 may be corresponding to the size of the first pixel opening K1, the size of the second sub-pixel area X2 may be corresponding to the size of the second pixel opening K2, and the size of the third sub-pixel area X3 may be corresponding to the size of the third pixel opening K3. In the embodiments of the present application, when adjusting the dimensions of the first light shielding unit Z1, the second light shielding unit Z2, and the third light shielding unit Z3 to reduce diffraction, the first pixel opening K1, the second pixel opening K2, and the third pixel opening K3 may maintain their original sizes, i.e., the opening ratio of the display panel is unchanged, so as to ensure that the display effect of the display panel is not affected. The orthographic projection of the first light shielding unit Z1 on the pixel defining layer 2 being at least partially located within the first pixel opening K1 only represents a positional relationship between the orthographic projection of the first light shielding unit Z1 and the first pixel opening K1, without indicating that the first light shielding unit Z1 is located within the first pixel opening K1.

In the embodiment, the material of the pixel defining layer 2 may be hexamethyl disiloxane, epoxy resin or Polyimide (PI), or other silicone adhesive materials with a light transmittance of 90% or greater, or other organic adhesive materials with a slightly lower light transmittance (greater than 80%) and a slightly higher flexural strength, which is not limited in the embodiment.

Optionally, as shown in Fig. 2, the display panel further includes an anode layer Y, and at least a portion of the anode layer Y is reused as the light shielding layer. It may be understood that, in addition to the anode layer Y, the display panel further includes a light-emitting material layer 3, a cathode layer 4, a metal wiring, a pixel circuit element, a substrate, and other functional layers of the display panel, and the light transmittance of the materials used for these functional layers of the display panel is relatively high.

In the embodiment, since the anode layer Y also needs to be arranged corresponding to the pixel opening in the pixel defining layer 2 and has a relatively low light transmittance, at least a portion of the anode layer Y may be reused as the light shielding layer, and the diffraction problem can be alleviated by adjusting the size of the anode layer Y.

Optionally, the material of the anode layer Y is generally a material with high work function to increase hole injection efficiency, and the anode layer Y may include a single-layer film layer such as gold (Au), platinum (Pt), titanium (Ti), silver (Ag), or a composite structural layer such as an indium tin oxide-silver-indium tin oxide film layer. The material of the cathode layer 4 is generally a material with relatively low work function to facilitate electron injection, and further to reduce the heat generated during operation and extend the service life of the OLED device. The material of the cathode layer 4 may be one of metal materials such as silver, aluminum, lithium, magnesium (Mg), ytterbium (Yb), calcium (Ca), or indium (In) and the like, or an alloy of these metal materials, such as a magnesium-silver alloy (Mg/Ag), a lithium-aluminum alloy (Li/Al). Since the material used for the cathode layer 4 has a high light transmittance and the cathode layer 4 is generally arranged as a whole, the cathode layer 4 will not affect the diffraction.

Reference is made to Fig. 2, in some optional embodiments, the anode layer Y includes a first sub-electrode Y1 reused as the first light shielding unit Z1, a second sub-electrode Y2 reused as the second light shielding unit Z2, and a third sub-electrode Y3 reused as the third light shielding unit Z3; and the first sub-electrode Y1, the second sub-electrode Y2, and the third sub-electrode Y3 are all reflective electrodes.

In the embodiment, the first sub-electrode Y1, the second sub-electrode Y2, and the third sub-electrode Y3 may all be made of opaque metals to achieve light shielding effect, so as to facilitate reusing the first sub-electrode Y1 as the first light shielding unit Z1, reusing the second sub-electrode Y2 as the second light shielding unit Z2, and reusing the third sub-electrode Y3 as the third light shielding unit Z3. In the embodiment, the first sub-electrode Y1, the second sub-electrode Y2, and the third sub-electrode Y3 are all reflective electrodes, that is, the anode layer Y may include a single-layer structure which includes only one electrode layer capable of shielding light, and the anode layer Y is reused as the light shielding layer by its entirety.

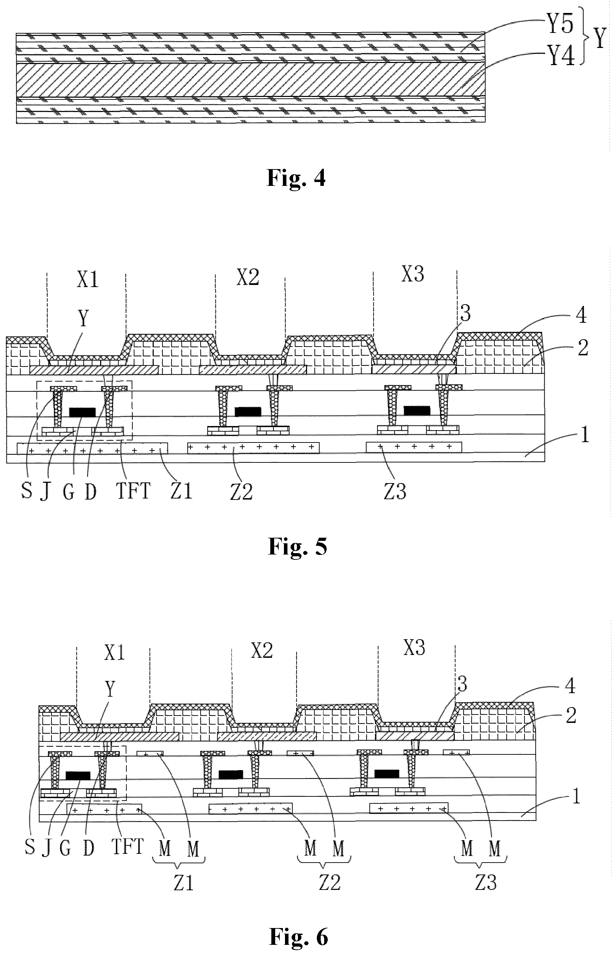

Reference is made to Fig. 4, in some other optional embodiments, the anode layer Y includes a reflective electrode layer Y4 reused as the light shielding layer. In the embodiment, in addition to the reflective electrode layer Y4, the anode layer Y may further include other film layers to ensure signal transmission effect of the anode layer Y For example, the anode layer Y further includes at least one light-transmitting electrode layer Y5, which may specifically be made of indium tin oxide and have a high light transmittance.

Optionally, the anode layer Y includes two light-transmitting electrode layers Y5 arranged at two sides of the reflective electrode layer Y4, respectively. For example, the light-transmitting electrode layer Y5 may adopt indium tin oxide. The reflective electrode layer Y4 may adopt silver, and the anode layer Y includes a composite film layer structure of indium tin oxide-silver-indium tin oxide.

In addition to reusing the anode layer Y as the light shielding layer as described above, a light shielding layer may be additionally arranged, and reference is made to Fig. 5, specifically, the light shielding layer is arranged between the anode layer Y and the base plate 1.

In the embodiment, the light shielding layer may be manufactured by an additional process, and for example, the first light shielding unit Z1, the second light shielding unit Z2, and the third light shielding unit Z3 each include at least one of a black adhesive layer, ink, or metal. Alternatively, a portion originally located between the anode layer Y and the base plate 1, which is made of light shielding material, may be reused as the light shielding layer, so as to reduce cost.

For example, the display panel further includes a pixel circuit electrically connected to the anode layer Y The pixel circuit includes a signal line and a thin-film transistor TFT including an active layer J, a gate G, a source S, and a drain D. The material of the drain D, the source S, and the gate G may include a combination of one or more of molybdenum, titanium, aluminum, copper, and the like. The gate G of the thin-film transistor TFT is generally used to receive a control signal to cause the thin-film transistor TFT to be turned on/off under the control of the control signal. One of the source S and the drain D of the thin-film transistor TFT is connected to the anode layer Y.

A portion of the signal line of the pixel circuit or the gate G, the source S, and the drain D may be made of non-light-transmitting metals, and thus this portion of non-light-transmitting film layer may be partially reused as the light shielding layer to reduce cost.

Reference is made to Fig. 6, in some optional embodiments, the first light shielding unit Z1, the second light shielding unit Z2, and the third light shielding unit Z3 each include at least two sub-light shielding portions M. At least two of the sub-light shielding portions M in the first light shielding unit Z1 are arranged in different layers; at least two of the sub-light shielding portions M in the second light shielding unit Z2 are arranged in different layers; and at least two of the sub-light shielding portions M in the third light shielding unit Z3 are arranged in different layers. The above configuration may be applied to one, two, or three of the first light shielding unit Z1, the second light shielding unit Z2, and the third light shielding unit Z3.

It may be understood that in the embodiment, the first light shielding unit Z1 may be formed by at least two sub-light shielding portions M, and at least two of the sub-light shielding portions M forming the first light shielding unit Z1 are arranged in different layers, so as to reasonably utilize space in each layer for facilitating arrangement.

It should be noted that the shape formed by splicing the orthographic projections of the various sub-light shielding portions M in the first light shielding unit Z1 on the base plate 1 is the desired shape of the orthographic projection of the first light shielding unit Z1 on the base plate 1. Similarly, the shape formed by splicing the orthographic projections of the various sub-light shielding portions M in the second light shielding unit Z2/the third light shielding unit Z3 on the base plate 1 is the desired shape of the orthographic projection of the second light shielding unit Z2/the third light shielding unit Z3 on the base plate 1. For example, one of the sub-light shielding portions M in the first light shielding unit Z1 is arranged in the same layer as the source, while another of the sub-light shielding portions M may be arranged in the same layer as the gate or the active layer, provided that the various sub-light shielding portions M can form the desired shape of the first light shielding unit Z1.

In some optional embodiments, the first light shielding unit Z1, the second light shielding unit Z2, and the third light shielding unit Z3 are all of a similar pattern.

The similar pattern specifically means that the first light shielding unit Z1, the second light shielding unit Z2, and the third light shielding unit Z3 are of a same shape. For example, the first light shielding unit Z1, the second light shielding unit Z2, and the third light shielding unit Z3 may all be circular in shape, but have different radiuses; alternatively, the first light shielding unit Z1, the second light shielding unit Z2, and the third light shielding unit Z3 may all be elliptical in shape, and the second light shielding unit Z2 may be proportionately scaled up or down to obtain the first light shielding unit Z1 and the third light shielding unit Z3, i.e., a ratio between the minor axis and major axis is constant for the first light shielding unit Z1, the second light shielding unit Z2, and the third light shielding unit Z3 that are elliptical in shape.

Specifically, the first light shielding unit Z1, the second light shielding unit Z2, and the third light shielding unit Z3 may be circular or circle-like in shape. The inventors have found through experiments that when the first light shielding unit Z1, the second light shielding unit Z2, and the third light shielding unit Z3 are circular or circle-like in shape, by defining the outline dimension of the orthographic projection of the second light shielding unit Z2 on the base plate 1 to be close to the average of the outline dimensions of the orthographic projections of the first light shielding unit Z1 and the third light shielding unit Z3 on the base plate 1, the reducing of the diffraction problem is obvious.

Reference is made to Fig. 3, in some optional embodiments, the orthographic projections of the first light shielding unit Z1, the second light shielding unit Z2, and the third light shielding unit Z3 on the base plate 1 are all circular in shape; and a difference between a diameter of the second light shielding unit Z2 and an average of diameters of the first light shielding unit Z1 and the third light shielding unit Z3 is less than or equal to 2 µm.

The inventors have found through experiments that if the first light shielding unit Z1, the second light shielding unit Z2, and the third light shielding unit Z3 are all circular in shape, the resulting diffraction pattern is similar to concentric circles, and when the diameter of the second light shielding unit Z2 is adjusted to be closer to the average of diameters of the first light shielding unit Z1 and the third light shielding unit Z3, the diffracted lights are more converged to the center of the diffraction pattern, which effectively reduces the dispersion of the diffracted lights.

The difference between the diameter of the second light shielding unit Z2 and the average of diameters of the first light shielding unit Z1 and the third light shielding unit Z3 is less than or equal to 2 µm, which means that a difference between the radius of the second light shielding unit Z2 and an average of radiuses of the first light shielding unit Z1 and the third light shielding unit Z3 is less than or equal to 1 µm. For example, the radius of the first light shielding unit Z1 is 10.1 µm, and the radius of the third light shielding unit Z3 is 7.3 µm, then the average of radiuses of the first light shielding unit Z1 and the third light shielding unit Z3 is 8.7 µm, and thus the radius of the second light shielding unit Z2 needs to be between 8.6 µm and 8.8 µm.

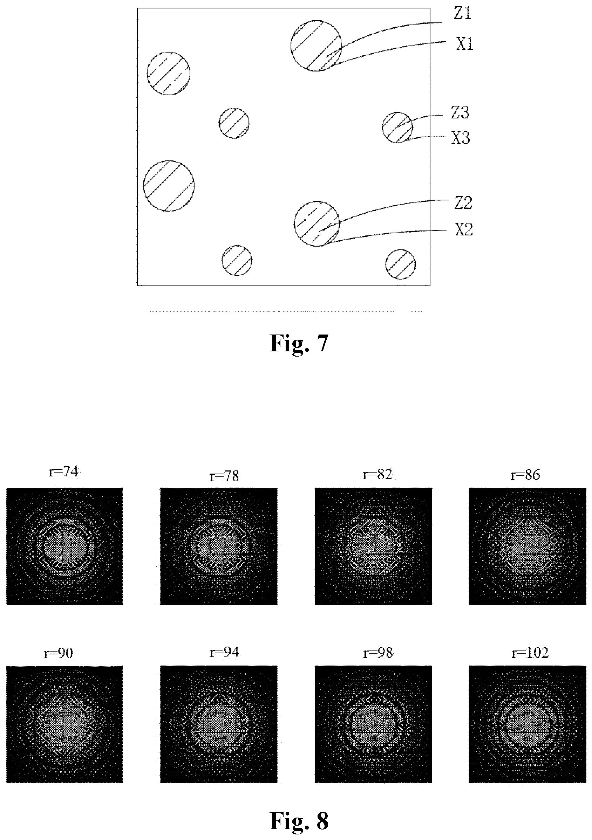

The inventors have found through experiments that the technical solutions provided by the embodiments of the present application can effectively alleviate the diffraction problem for a variety of pixel arrangement structures. Reference is made to Figs. 7 to 12, in which, for example, the orthographic projections of the first light shielding unit Z1, the second light shielding unit Z2, and the third light shielding unit Z3 on the base plate 1 are circular in shape, the radius of the first light shielding unit Z1 is fixed to be 10.1 µm, the radius of the third light shielding unit Z3 is fixed to be 7.3 µm, and the radius of the second light shielding unit Z2 is varied from 7.4 µm to 10.2 µm for simulation experiments. The diffraction effect for the second sub-pixel area X2 corresponding to the second light shielding unit Z2 is shown in Figs. 8, 10, and 12, from which it may be found that the diffraction light intensity is the most convergent and the diffraction effect is the best when the radius of the second light shielding unit Z2 is between 8.6 µm and 9.0 µm. Moreover, 8.8 µm is in the middle of 8.6 µm and 9.0 µm, and the average of the radius 10.1 µm of the first light shielding unit Z1 and the radius 7.3 µm of the third light shielding unit Z3 is 8.7 µm, which is exactly between 8.6 µm and 9.0 µm, thereby further illustrating that the solutions of the embodiments of the present application can effectively alleviate the diffraction problem.

As can be seen from the diffraction effect diagrams obtained from the above simulation experiments, the technical solutions provided by the present application in which the difference between the maximum outline dimension of the orthographic projection of the second light shielding unit Z2 on the base plate 1 and the average of the maximum outline dimensions of the orthographic projections of the first light shielding unit Z1 and the third light shielding unit Z3 on the base plate 1 is less than or equal to the preset value are applicable to a variety of pixel arrangement structures.

Optionally, the maximum outline dimension of the second light shielding unit Z2 may be equal to the average of the maximum outline dimensions of the first light shielding unit Z1 and the third light shielding unit Z3, so as to alleviate the diffraction problem. For example, if the radius of the first light shielding unit Z1 is 10.1 µm and the radius of the third light shielding unit Z3 is 7.3 µm, then the radius of the second light shielding unit Z2 may be 8.7 µm.

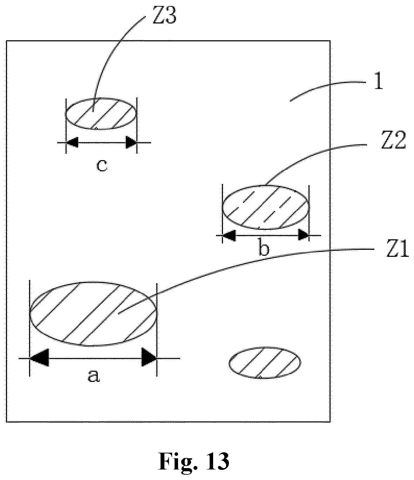

Reference is made to Fig. 13, optionally, the orthographic projections of the first light shielding unit Z1, the second light shielding unit Z2, and the third light shielding unit Z3 on the base plate 1 may be of other shapes than circle. For example, the orthographic projections of the first light shielding unit Z1, the second light shielding unit Z2, and the third light shielding unit Z3 on the base plate 1 are all elliptical in shape; a difference between a major axis length of the second light shielding unit Z2 and an average of major axis lengths of the first light shielding unit Z1 and the third light shielding unit Z3 is less than or equal to 2 µm; and/or a difference between a minor axis length of the second light shielding unit Z2 and an average of minor axis lengths of the first light shielding unit Z1 and the third light shielding unit Z3 is less than or equal to 1 µm.

It may be understood that the major axis length of the ellipse is greater than the minor axis length, and thus the difference between the major axis length of the second light shielding unit Z2 and the average of major axis lengths of the first light shielding unit Z1 and the third light shielding unit Z3 should also be correspondingly greater than the difference between the minor axis length of the second light shielding unit Z2 and the average of minor axis lengths of the first light shielding unit Z1 and the third light shielding unit Z3, so as to ensure that the adjustments of the major axis length and the minor axis length of the first light shielding unit Z1 have uniform effect on the diffraction. Obviously, in addition to circle and ellipse, the first light shielding unit Z1, the second light shielding unit Z2, and the third light shielding unit Z3 may be of other circle-like shapes, such as a quadrilateral with four rounded corners, which is not specifically limited.

The embodiments of the present application further provide a display apparatus including the display panel in any of the above embodiments.

Optionally, the display area AA of the display panel includes a first display area AA1 and a second display area AA2 that are adjacent, and a light transmittance of the first display area AA1 is greater than a light transmittance of the second display area AA2; and the display apparatus further includes an optical element arranged corresponding to the first display area AA1.

The optical element may specifically be an element with certain requirement for light such as a camera and a fingerprint recognition element.

By setting the first light shielding unit Z1, the second light shielding unit Z2, and the third light shielding unit Z3 as a patten with arc edges, and setting the difference between the maximum outline dimension of the orthographic projection of the second light shielding unit Z2 on the base plate 1 and the average of the maximum outline dimensions of the orthographic projections of the first light shielding unit Z1 and the third light shielding unit Z3 on the base plate 1 to be less than or equal to the preset value, the diffraction effect of external light in the first display area AA1 can be adjusted to alleviate the diffraction problem, thereby improving the operation of the optical element.

The display apparatus according to the embodiments of the present application has the technical effects of the technical solutions of the display panel in any of the above embodiments, and the same or corresponding structures as the above embodiments and the explanation of the terms will not be repeated herein.

The display apparatus according to the embodiments of the present application can be applied to a cellular phone or any electronic product with display function, including, but not limited to: a television, a laptop computer, a desktop display panel, a tablet computer, a digital camera, a smart bracelet, smart glasses, an on-board display panel, a medical device, an industrial control device, a touch interaction terminal, etc., which is not specifically limited in the embodiments of the present application.

## Claims

1. A display panel with a display area and a non-display area, the display area comprising a first sub-pixel area, a second sub-pixel area, and a third sub-pixel area emitting lights of different colors, the display panel comprising:
a base plate; and
a light shielding layer arranged at a side of the base plate and comprising a first light shielding unit located in the first sub-pixel area, a second light shielding unit located in the second sub-pixel area, and a third light shielding unit located in the third sub-pixel area;
wherein outlines of orthographic projections of the first light shielding unit, the second light shielding unit, and the third light shielding unit on the base plate each form a pattern with curved edges, outline dimensions of the orthographic projections of the first light shielding unit, the second light shielding unit, and the third light shielding unit on the base plate are decreased sequentially, and a difference between the outline dimension of the orthographic projection of the second light shielding unit on the base plate and an average of the outline dimensions of the orthographic projections of the first light shielding unit and the third light shielding unit on the base plate is less than or equal to a preset value.

2. The display panel according to claim **1,** wherein the preset value is less than or equal to 2 µm.

3. The display panel according to claim **1,** wherein a maximum outline dimension of the orthographic projection of the second light shielding unit on the base plate is equal to an average of maximum outline dimensions of the orthographic projections of the first light shielding unit and the third light shielding unit on the base plate.

4. The display panel according to claim 1, further comprising a pixel defining layer arranged at a side of the base plate and comprising a first pixel opening, a second pixel opening, and a third pixel opening;
wherein an orthographic projection of the first light shielding unit on the pixel defining layer is at least partially located within the first pixel opening, an orthographic projection of the second light shielding unit on the pixel defining layer is at least partially located within the second pixel opening, and an orthographic projection of the third light shielding unit on the pixel defining layer is at least partially located within the third pixel opening.

5. The display panel according to claim 4, further comprising an anode layer, and at least a portion of the anode layer being reused as the light shielding layer.

6. The display panel according to claim 5, wherein the anode layer comprises a first sub-electrode reused as the first light shielding unit, a second sub-electrode reused as the second light shielding unit, and a third sub-electrode reused as the third light shielding unit; and
the first sub-electrode, the second sub-electrode, and the third sub-electrode are all reflective electrodes.

7. The display panel according to claim 5, wherein the anode layer comprises a reflective electrode layer reused as the light shielding layer.

8. The display panel according to claim 7, wherein the anode layer further comprises at least one light-transmitting electrode layer.

9. The display panel according to claim 8, wherein the anode layer comprises two light-transmitting electrode layers arranged at two sides of the reflective electrode layer, respectively.

10. The display panel according to claim 4, further comprising an anode layer, and the light shielding layer being arranged between the anode layer and the base plate.

11. The display panel according to claim 10, wherein the light shielding layer is located between the anode layer and the base plate; and
the first light shielding unit, the second light shielding unit, and the third light shielding unit each comprise at least one of a black adhesive layer, ink, or metal.

12. The display panel according to claim 1, wherein the first light shielding unit, the second light shielding unit, and the third light shielding unit each comprise at least two sub-light shielding portions;
at least two of the sub-light shielding portions in the first light shielding unit are arranged in different layers; and/or
at least two of the sub-light shielding portions in the second light shielding unit are arranged in different layers; and/or
at least two of the sub-light shielding portions in the third light shielding unit are arranged in different layers.

13. The display panel according to claim 1, wherein the orthographic projections of the first light shielding unit, the second light shielding unit, and the third light shielding unit on the base plate are of a similar pattern.

14. The display panel according to claim 1, wherein the orthographic projections of the first light shielding unit, the second light shielding unit, and the third light shielding unit on the base plate are all circular in shape; and
a difference between a diameter of the second light shielding unit and an average of diameters of the first light shielding unit and the third light shielding unit is less than or equal to 2 µm.

15. The display panel according to claim 1, wherein the orthographic projections of the first light shielding unit, the second light shielding unit, and the third light shielding unit on the base plate are all elliptical in shape.

16. The display panel according to claim 15, wherein a difference between a major axis length of the second light shielding unit and an average of major axis lengths of the first light shielding unit and the third light shielding unit is less than or equal to 2 µm.

17. The display panel according to claim 15, wherein a difference between a minor axis length of the second light shielding unit and an average of minor axis lengths of the first light shielding unit and the third light shielding unit is less than or equal to 1 µm.

18. The display panel according to claim 1, wherein the display area comprises a first display area and a second display area that are adjacent, a light transmittance of the first display area is greater than a light transmittance of the second display area, and the light shielding layer is arranged at least in the first display area.

19. A display apparatus comprising the display panel according to any one of claims 1 to 18.

20. The display apparatus according to claim 19, wherein the display area of the display panel comprises a first display area and a second display area that are adjacent, and a light transmittance of the first display area is greater than a light transmittance of the second display area; and
the display apparatus further comprises an optical element arranged corresponding to the first display area.
